# EUROPEAN PATENT SPECIFICATION

(11) **EP 2 947 683 B1**
(45) Date of publication and mention of the grant of the patent: **15.07.2020**
(21) Application number: 15164662.7
(22) Date of filing: 22.04.2015
(51) Int. Cl.: H01L 21/56, H01L 23/31, H01L 21/48, H01L 23/498, H01L 23/538

(54) **SEMICONDUCTOR PACKAGE, MOLDED ARRAY OF SEMICONDUCTOR PACKAGES AND METHOD OF FORMING A SEMICONDUCTOR PACKAGE**
HALBLEITERGEHÄUSE, GEFORMTE ARRAY VON HALBLEITERGEHÄUSEN UND VERFAHREN ZUR HERSTELLUNG EINES HALBLEITERGEHÄUSES
BOÎTIER SEMI-CONDUCTEUR, MATRICE MOULÉE DE BOÎTIERS SEMI-CONDUCTEURS ET PROCEDE DE FABRICATION D'UN BOÎTIER SEMI-CONDUCTEUR

(30) Priority: 21.05.2014 US 201462001367 P; 03.07.2014 US 201414323759
(43) Date of publication of application: 25.11.2015
(73) Proprietor: Avago Technologies International Sales Pte. Limited, Singapore 768923 (SG)
(72) Inventor: Law, Edward, Ladera Ranch, CA 92694 (US); Zhao, Sam Ziqun, Irvine, CA 92618 (US); Hu, Kunzhong, Irvine, CA 92618 (US); Khan, Rezaur Rahman, Irvine, CA 92618 (US)
(74) Representative: Bosch Jehle Patentanwaltsgesellschaft mbH

(56) References cited:
- US-A- 5 431 332
- US-A1- 2009 108 433
- US-A1- 2012 032 340
- US-A1- 2012 217 645
- US-A1- 2013 193 996

## Description

### RELATED APPLICATIONS

### BACKGROUND

A semiconductor package can be a metal, plastic, glass, or ceramic casing containing one or more semiconductor electronic components, also referred to as dies or integrated circuits (ICs). The package provides protection against impact and corrosion, as well as environmental factors, such as moisture, oxidation, heat, and contaminants. Electrical contacts or leads emminate from the package and are connected to other devices and/or to an intermediary substrate, or directly to a circuit board. The package may have as few as two leads or contacts for devices such as diodes, or have several hundred leads or contacts in the case of a microprocessor.

The semiconductor package can be a special purpose self-contained device, which can be mounted to a printed circuit board (PCB) or a printed wiring board (PWB) of an end product. ICs can be connected to a substrate in a variety of layouts, as well as stacked in multiple layers. In addition, packages can be mounted upon other packages to form a package-on-package device.

User products are becoming more complicated with several features and functions. In addition, many user products are becoming smaller, especially wireless devices. As a result, manufacturers are utilizing packaging alternatives as a way of achieving more features and functions in a smaller area.

US 2012/032340 A1 discloses a semiconductor device having a conductive through silicon vias (TSV) wafer and semiconductor die mounted over the wafer, wherein a channel is formed through the wafer. An encapsulant is deposited over the semiconductor die and the wafer, and conductive through mold vias (TMV) are formed through the encapsulant over the conductive TSV and contact pads of the semiconductor die, wherein the conductive TMV can be formed through the channel. A conductive layer is formed over the encapsulant and electrically connected to the conductive TMV, and an insulating layer is formed over the encapsulant and conductive layer. A plurality of semiconductor dies of the same size or different sizes can be stacked over the TSV wafer, and the plurality of semiconductor dies can be stacked over opposite sides of the TSV wafer, wherein an internal stacking module can be stacked over the semiconductor die and electrically connected through the conductive TMV.

US 2013/3193996 A1 discloses a testable semiconductor package that includes an active die having interface contacts and dedicated testing contacts, wherein an interposer is situated adjacent a bottom surface of the active die, the interposer providing electrical connections between the interface contacts and a bottom surface of the testable semiconductor package. At least one conductive medium provides electrical connection between at least one of the dedicated testing contacts and a top surface of the testable semiconductor package, wherein the at least one conductive medium can be coupled to a package-top testing connection, which may include a solder ball.

### SUMMARY

In accordance with the invention a semiconductor package is provided as defined in claim 1, a molded array of packages as defined in claim 5 and a method of forming a semiconductor package as defined in claim 7. Preferred embodiments of the invention are presented in the dependent claims.

The foregoing paragraphs have been provided by way of general introduction, and are not intended to limit the scope of the following claims. The described embodiments, together with further advantages, will be best understood by reference to the following detailed description taken in conjunction with the accompanying drawings.

### BRIEF DESCRIPTION OF THE DRAWINGS

A more complete appreciation of the disclosure and many of the attendant advantages thereof will be readily obtained as the same becomes better understood by reference to the following detailed description when considered in connection with the accompanying drawings, wherein:
Figs. 1A-1B are illustrations of an IC wafer and an individual singulated IC, according to an example;
Figs. 2A-2B are illustrations of bonding pad patterns on an active surface of an IC according to an example;
Figs. 3A-3B are illustrations of a substrate panel and an individual die-attach substrate according to an example;
Figs. 4A-4B are illustrations of an IC solder-bump attached to a die-attach substrate according to an example;
Fig. 4C is an illustration of an IC wire-bonded to a die-attach substrate according to an example;
Figs. 5A-5B are illustrations of a substrate panel and an individual interposer substrate according to an example;
Fig. 5C is an illustration of an interposer substrate formation according to an example;
Figs. 5D-5E are illustrations of connecting an interposer substrate to a die-attach substrate containing a flip chip IC according to an example;
Fig. 5F is an illustration of an interposer substrate connected to a die-attach substrate containing a wire-bonded IC according to an example;
Fig. 6 contains illustrations of die-attach adhesive patterns according to an example;
Figs. 7A-7B are illustrations of reconstituted packages mounted to a carrier according to an example;
Fig. 8A illustrates a molding compound filled within and around the reconstituted packages according to an example;
Fig. 8B illustrates removal of the molding film and carrier, and solder ball external connections according to an example;
Fig. 8C illustrates singulation of the reconstituted packages according to an example;
Fig. 9A illustrates molding compound in place of die-attach adhesive according to an example;
Fig. 9B illustrates molding compound in place of die-attach adhesive and die underfill according to an example;
Figs. 10A-10E illustrate reconstituted interposer semiconductor packages according to some examples; and
Fig. 11 is a flowchart for a method of forming a semiconductor package according to an example.

Referring now to the drawings, wherein like reference numerals designate identical or corresponding parts throughout the several views.

### DETAILED DESCRIPTION OF THE EMBODIMENTS

Multiple ICs can be assembled on a substrate and be interconnected with wire bonds and/or a metal pattern to form a package. An example of a multi-chip IC package is an application microprocessor, which may include separate ICs for such things as memory within the same package.

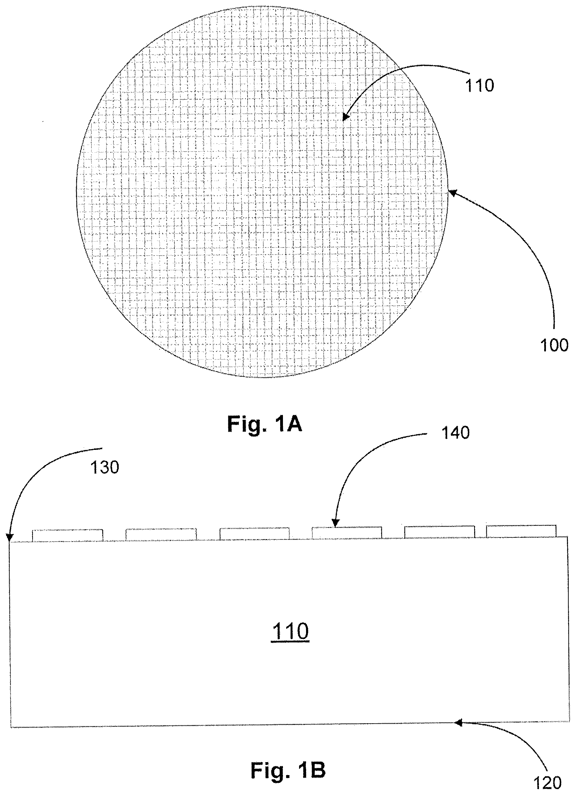

ICs can be manufactured in wafer level form, in which 10s, 100s, or 1000s of ICs are formed within a single semiconductor wafer. The wafer material may be silicon, gallium arsenide, or other semiconducting material. Fig. 1A illustrates a wafer 100 containing multiple ICs 110. The ICs 110 can be square or rectangular in shape, as well as other shapes suited to a particular manufacturing process. The ICs 110 are separated from one another in a singulation process, which can be implemented by scribing the boundaries between the individual ICs 110, then sawing, breaking, or cutting the ICs 110 apart.

Fig. 1B illustrates a cross sectional area of an IC 110. The IC 110 has an inactive surface 120 and an active surface 130. The active surface 130 has a plurality of electrically conductive contact regions or contact pads 140, which are designed to interconnect the IC 110 with other devices or substrates. An IC contact pad can have multiple layers, referred to as under-bump metallization (UBM). The base conductive layer may contain aluminum. Since solder material does not adhere well to aluminum, another metallic or conductive layer can be patterned over the aluminum pad. An example UBM may include a combination of aluminum, nickel vanadium, and copper. However, several other UBM materials are contemplated. A contact pad, referred to herein may include a UBM layer.

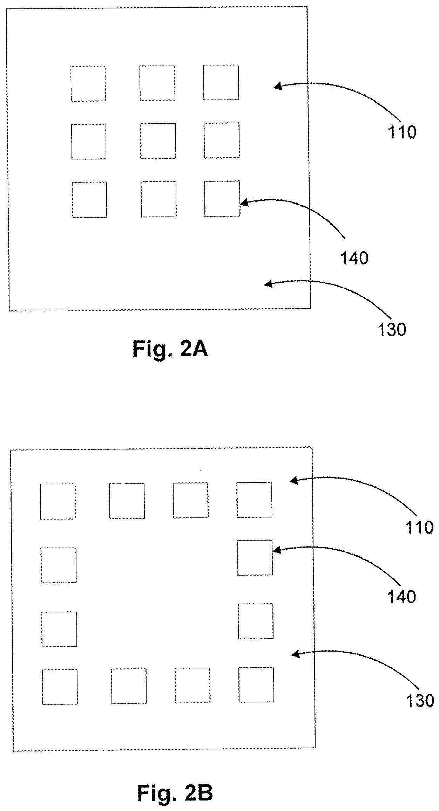

The contact pads 140 can be arranged in various configurations, depending upon the medium in which it will be connected to another device or substrate. Fig. 2A illustrates a top view of IC 110, showing multiple contact pads 140 arranged primarily in the center of the active surface 130 of the IC 110. This configuration can be used for a flip chip type of device, in which the device can have solder bumps or copper pillars connected to the contact pads 140. The flip chip device and connected solder bumps are "flipped over" and connected to contact pads of another device or substrate. Fig. 2B illustrates a top view of IC 110, showing multiple contact pads 140 arranged primarily around the perimeter of the active surface 130 of the IC 110. This configuration can be used for a wire bonded type of device. The wire bonded device is attached, such as stacked devices or side-by-side wire bonded devices. Bonding wires connect the contact pads 140 of the wire bonded device to contact pads of another device or substrate.

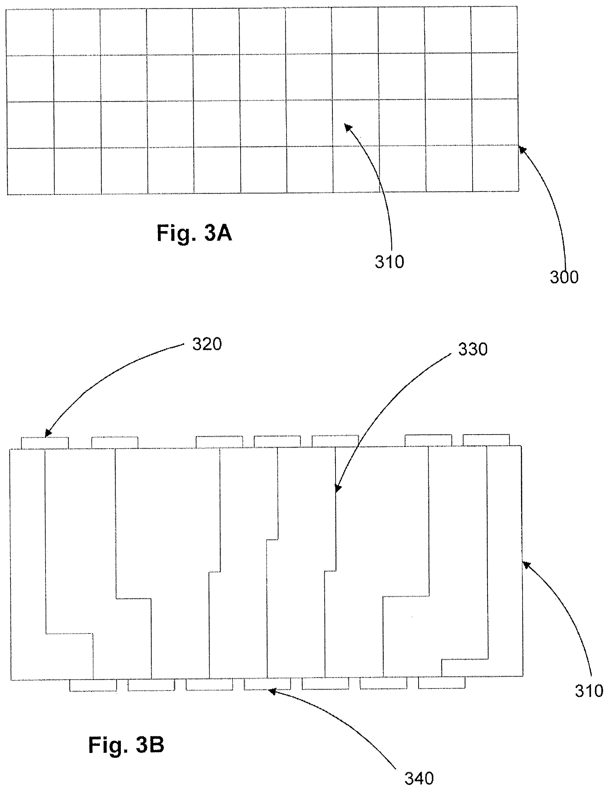

Fig. 3A illustrates a substrate panel 300, which can be used to form multiple die-attach substrates, shown individually as 310. The substrate panel 300 can be made of a material, such as flex tape material, ceramic material, organic laminate material, resin-based material, lead frame, or other similar materials in which one or more ICs 110 can be supported. The substrate panel 300 is formed to include one or more routing layers and one or more electrically insulating layers. Electrically conductive vias are formed through the electrically insulating layers. Conductive contact pads on a first surface of the substrate panel 300 are connected through the substrate panel 300 by routing layers and vias to contact pads on a second surface of the substrate panel 300.

The substrate panel 300 is separated into individual die-attach substrates 310, which can be singulated similar to the wafer 100 singulation described above. Fig. 3B illustrates a cross section of an exemplary individual die-attach substrate 310. The die-attach substrate 310 has metallization or contact pads 320 patterned on a first surface. Conductive vias 330 are formed through the die-attach substrate 310 and are electrically connected to contact pads 340 located on a second surface of the die-attach substrate 310. The die-attach substrate 310 provides an interface to connect one or more ICs 110 on an upper surface, having a particular pattern of interconnecting contact pads to a PCB, for example having a different pattern of interconnecting contact pads or metallization. In an example, the lower contact pads 340 can be patterned to match a standard or commonly used PCB pattern.

After singulating the substrate panel 300 into individual die-attach substrates 310, the individual die-attach substrates 310 are tested and sorted into working substrates and failed substrates. Testing may include, but is not limited to functional tests by applying probes to conductive features of substrates to provide test signals and to measure test results. Environmental tests may also be performed, such as exposure to moisture, extreme temperatures, and shock. Die-attach substrates 310 that are determined to be non-working can be marked by an ink mark, a laser marking, or other type of mark for later identification as a non-working substrate. This provides the advantage of continued processing with only good working substrates. The failed substrates are removed early in the process before investing further materials and resources. The substrate testing may also be performed in panel 300 before singulation.

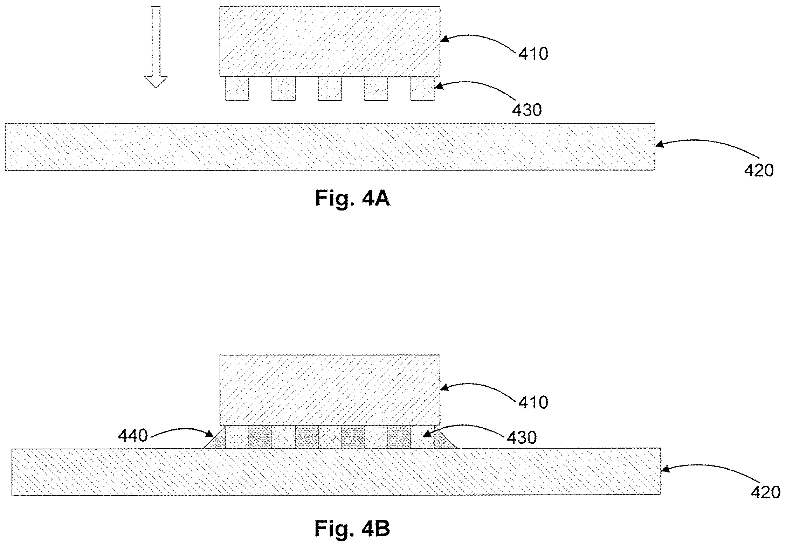

Fig. 4A illustrates an IC 410 in an inverted position with solder bumps 430 facing downward towards a die-attach substrate 420. The IC 410 is a flip chip, in which solder bumps 430 have been attached to the active surface of the IC 410. The solder bumps 430 may contain a metal core, such as copper with an outside solder film. The solder bumps 430 may also contain a solder material throughout, such as a tin/silver solder with no metal core. The solder bumps 430 may also be a copper post with tips coated with tin/silver solder. Fig. 4B illustrates the solder bumps 430 on the IC 410 are attached to contact pads on an upper surface of the die-attach substrate 420. A tacking material can be used to temporarily hold the ICs 410 in place with their respective die-attach substrates 420. For instance, solder flux can be applied to the contact pads to hold the solder bumps 430 in place until reflowing is completed. Figs. 4A and 4B illustrate just one IC 410 and one mating die-attach substrate 420 for simplicity. However, ICs 410 are mated to each of the working die-attach substrates 420 on a reconstitution carrier. The entire reconstitution carrier of die-attach substrates 420 and mated ICs 410 is exposed to a reflow process, at a temperature above the reflow temperature of the solder bumps 430. The reflow process mechanically and electrically connects each IC 410 to its respective die-attach substrate 420. A capillary underfill material 440 can be used to encapsulate the solder bumps 430 between each IC 410 and its respective die-attach substrate 420. The capillary underfill material 440 is an insulative and non-conducting material used to protect the solder bump connections from oxidation and other environmental and physical elements.

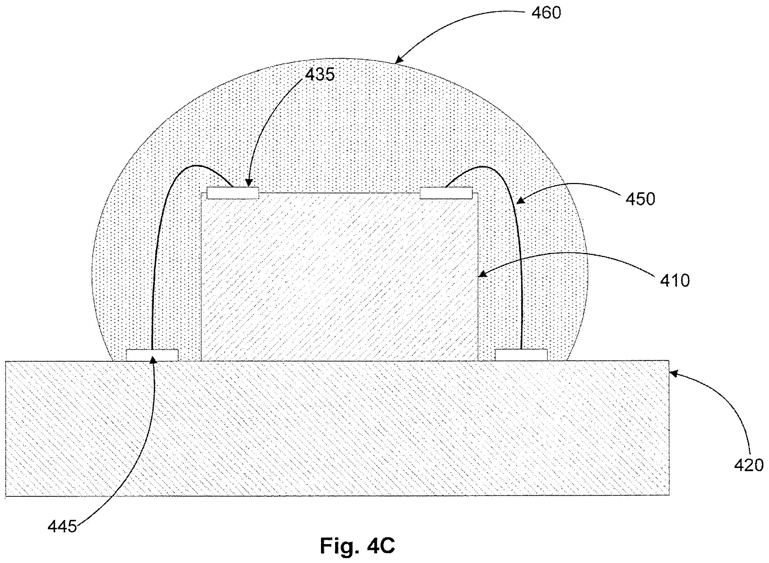

Fig. 4C illustrates an IC 410 connected to a die-attach substrate 420 in a face-up position. The inactive surface of the IC 410 is attached to the die-attach substrate 420 by an adhesive material. The active surface of the IC 410 contains contact pads 435, which are connected to contact pads 445 on the die-attach substrate 420 by bonding wires 450. The bonding wires 450 may be made of an oxidation-resistant material, such as gold, palladium-coated copper, or silver. An insulative encapsulation material 460 can be formed over the bonding wires 450 and contact pads 435 of the IC 410 and contact pads 445 of the die-attach substrate 420 to protect the bonding wires 450 and respective contact pads from physical and environmental elements. The optional encapsulation material 460 may be applied by means of a glob top process, as an example. Glob-top materials, such as silicone or an epoxy having high viscosity, such that it can be applied to a substantially planar surface without being laterally confined. However, other methods of encapsulating bonding wires and associated contact pads are contemplated. The encapsulation material 460 also provides an advantage of preventing wire sweep in a future molding process. The encapsulation material 460 over the bonding wires 450 prevents the bonding wires 450 from touching one another when a molding material flows over the IC 410. Fig. 4C illustrates just one IC 410 and one mating die-attach substrate 420 for simplicity. However, ICs 410 are mated to each of the working die-attach substrates 420 on a reconstitution carrier.

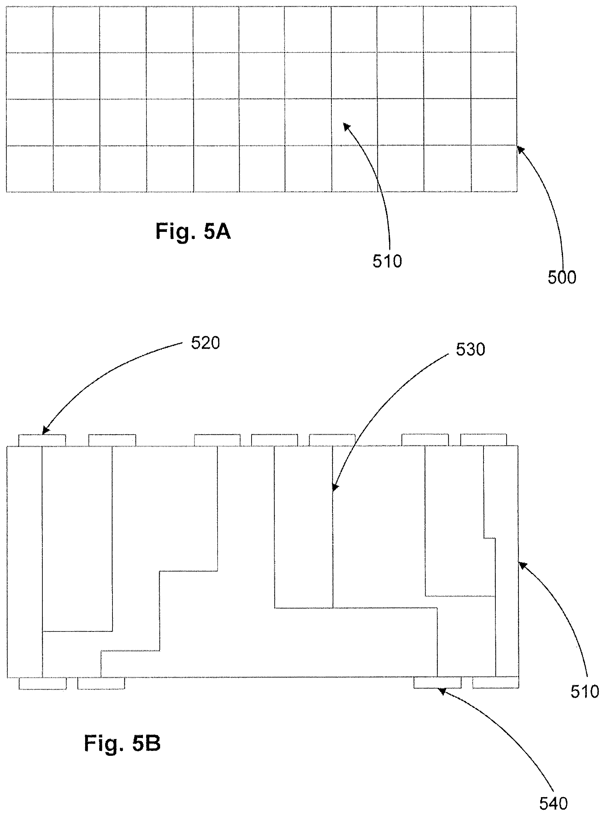

Figs. 5A-5F illustrate a process of forming and integrating an interposer substrate, in an example useful for understanding the present invention. The materials and processing can be similar to the die-attach substrate processing discussed above with reference to Figs. 3A-3B. Fig. 5A illustrates a substrate panel 500, which can be used to form multiple interposer substrates, shown individually as 510. The substrate panel 500 can be made of a material, such as flex tape material, ceramic material, organic laminate material, resin-based material, lead frame, or other similar materials. The substrate panel 500 is separated into individual interposer substrates 510, which can be singulated in a similar process as the wafer 100 singulation process described above.

Fig. 5B illustrates a cross section of an exemplary individual interposer substrate 510. The interposer substrate 510 has metallization or contact pads 520 patterned on a first surface. Conductive vias 530 are formed through the interposer substrate 510 and are electrically connected to contact pads 540 located on a second surface of the interposer substrate 510. The conductive vias 530 redirect the upper contact pads 520, patterned to receive additional devices or substrates to the lower contact pads 540, patterned to connect with a die-attach substrate, for example.

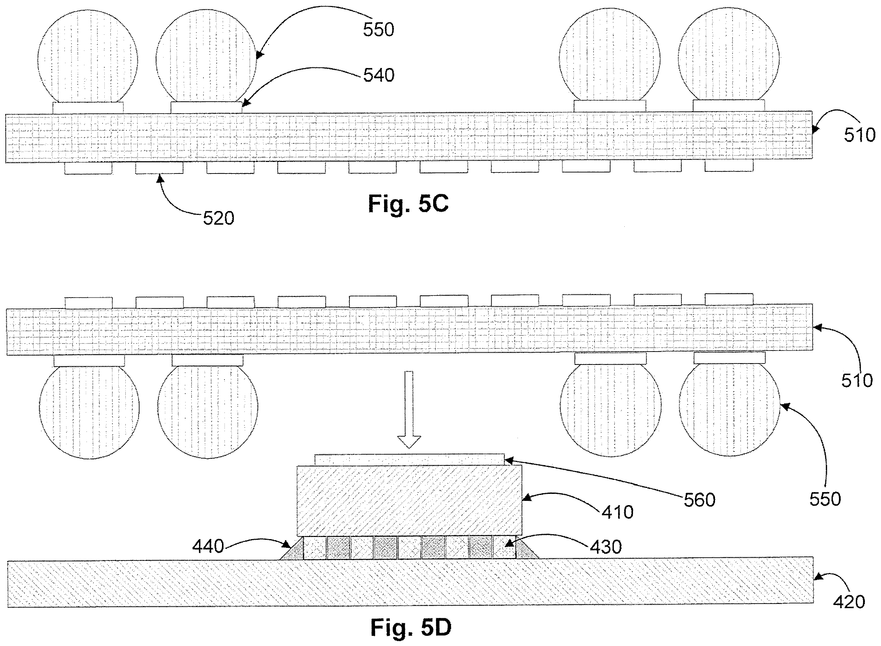

Fig. 5C illustrates solder balls 550 being connected to contact pads 540 on the second surface of the interposer substrate 510. The solder balls 550 can be temporarily held in place by a tacking material, such as solder flux during processing. The solder balls 550 are mechanically and electrically connected to the contact pads 540 of the interposer substrate 510 by exposing the combined interposer substrate 510 and solder balls 550 to a temperature above the reflow temperature of the solder balls 550.

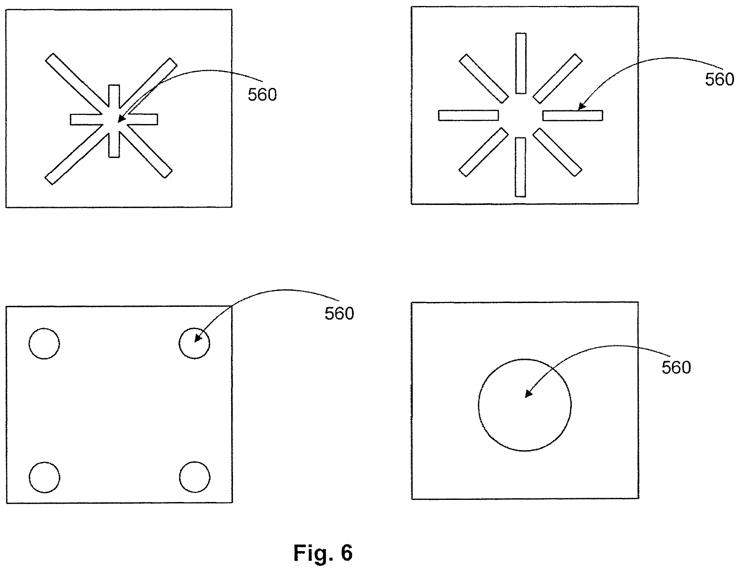

Fig. 5D illustrates how the interposer substrate 510 will be mounted over an IC 410 to a die-attach substrate 420. The solder balls 550 straddle the IC 410 located in the center of the die-attach substrate 420. The solder balls 550 are of a sufficient size to hold the interposer substrate 510 above the IC 410 when mounted. Fig. 5D illustrates a flip chip IC 410, in which the inactive surface of the IC 410 will be connected to the second surface of the interposer substrate 510. An adhesive 560 has been applied to the inactive surface of the IC 410. The adhesive 560 may include, but is not limited to an adhesive paste, a die-attach film, an epoxy solder flux, or other adhesive materials with properties that are suited for the adjoining materials of the IC 410 and the interposer substrate 510, and are suited for the operating temperatures of the IC 410. The adhesive 560 can be applied to the inactive surface of the IC 410 and/or the second surface of the interposer substrate 510 in a variety of patterns, as illustrated in Fig. 6. Other patterns of adhesive application are contemplated. The particular pattern may depend upon factors, such as but not limited to size of the IC 410, power level of the IC 410, heat dissipation of the IC 410, environmental exposure, intended use of the final semiconductor package, as well as other factors.

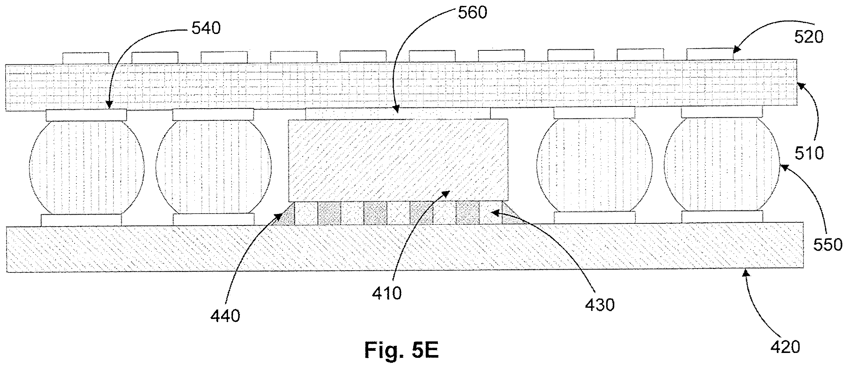

Fig. 5E illustrates an interposer substrate 510 mounted to a die-attach substrate 420 with a flip chip IC 410 mounted thereon to form a reconstituted semiconductor package. A tacking material, such as solder flux can be used to temporarily hold the solder balls 550 in place with contact pads of their respective die-attach substrates 420. The interposer substrate 510 is also adhered to the back side of the flip chip IC 410. The combined structure of Fig. 5E is exposed to a reflow process to mechanically and electrically connect the solder balls 550 to the contact pads of the die-attach substrate 420 (not shown in Fig. 5E). The adhesive 560 can be cured during the reflow process, or an additional process can be implemented to cure the adhesive 560, preferably after the reflow process. The interposer substrate 510 and the IC 410 can be attached in one reflow process.

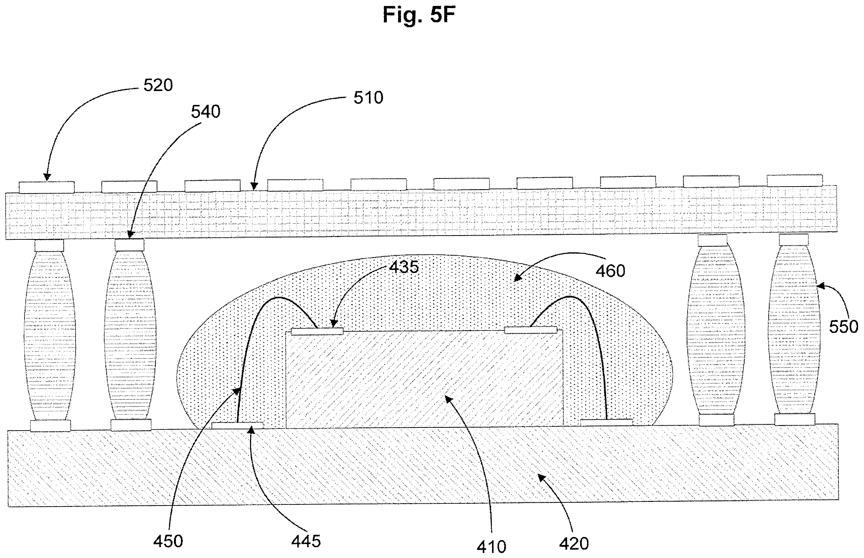

Fig. 5F illustrates an assembled die-attach substrate 420 and interposer substrate 510 for a wire bonded IC 410 to form another type of reconstituted semiconductor package. Since the active surface of the IC 410 is facing the interposer substrate 510, the interposer substrate 510 is not connected or adhered to the IC 410. The solder ballss 550 are of a sufficient size to hold the interposer substrate 510 above the IC 410. An additional example includes copper posts or solder columns in lieu of solder balls 550 to insure adequate height of the interposer substrate 510 above the IC 410. A tacking material can be used to temporarily hold the solder balls or copper posts 550 in place with their respective die-attach substrates 420 until a reflow process permanently connects the solder balls 550 to the two substrates.

Fig. 5E for a flip chip IC and Fig. 5F for a wire bonded IC are given for exemplary purposes only. Another type of IC that can be used with the structures described herein is an IC mounted to a lead frame, either with or without a die pad. With some adjustments, micro-electro-mechanical system (MEMS) devices and opto-electronic devices can be integrated into a reconstituted semiconductor package.

In the assembly process illustrated in Figs. 4A-5F, there are multiple reflow processes. For the flip chip IC 410, the solder bumps 430 are reflow connected to the die-attach substrate 420 (see Fig. 4A), the solder balls 550 are reflow connected to the interposer substrate 510 (see Fig. 5C), and the solder balls 550 are reflow connected to the die-attach substrate 420 (see Fig. 5E).

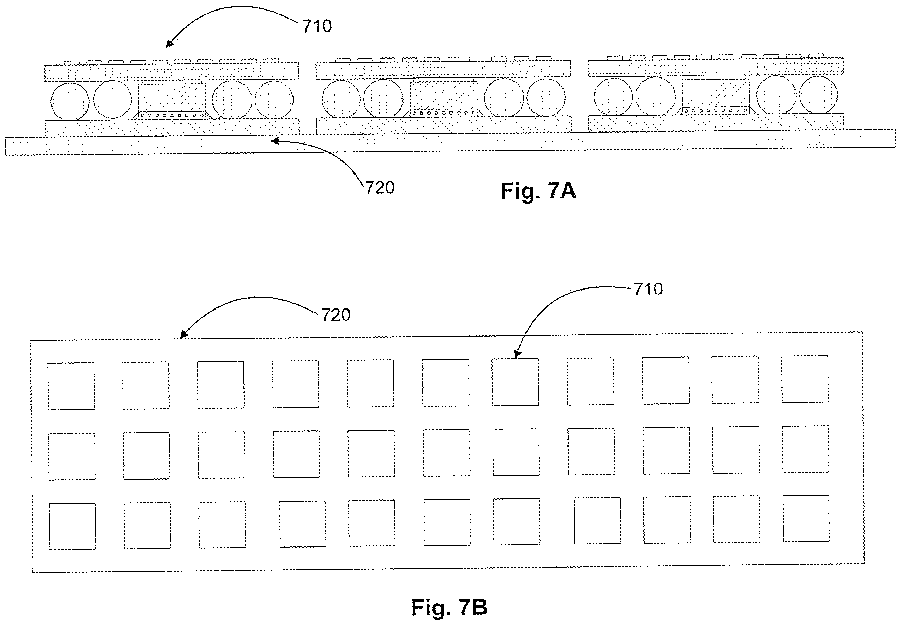

The reconstituted semiconductor packages described above can be prepared for mold-injection, in accordance with an embodiment of the invention. Fig. 7A illustrates multiple assembled packages 710 affixed to a reconstitution carrier 720. Each assembled package 710 comprises an IC mounted to a die-attach substrate at a first surface of the IC, and an interposer substrate mounted over a second surface of the IC, wherein the interposer substrate is electrically and mechanically connected to the die-attach substrate. The assembled packages 710 may contain the same type of IC or different types of ICs.

Fig. 7B illustrates a top view of the reconstitution carrier 720 in which individual assembled packages 710 are spaced apart in a rectangular array on the reconstitution carrier 720. A rectangular panel carrier is illustrated; however, other configured carriers are within the scope of the described embodiments, such as a square panel carrier or a long and narrow strip carrier. The reconstitution carrier 720 may have a variety of materials that is suitable for holding and transporting the array of assembled packages 710. Carrier materials may include, but are not limited to adhesion tape, ceramic, glass, plastic, semiconductor material, metal, or other material. An adhesive material can be applied to a surface of the carrier and/or to surfaces of the assembled packages 710. An adhesive material may include, but is not limited to epoxy or an adhesive film. An adhesive tape may be used to maintain the positions of the assembled packages 710 during processing. The adhesive tape can be a panel configuration, such as the reconstitution carrier 720, or it can be a roll or strip of adhesive tape for receiving the array of assembled packages 710.

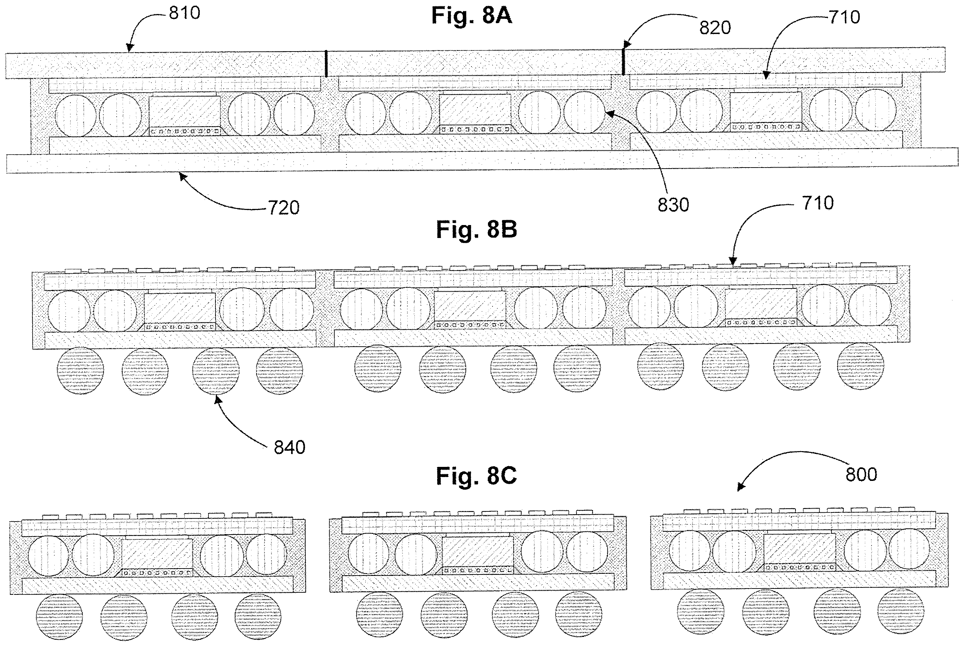

Fig. 8A illustrates the assembled packages 710 attached to the reconstitution carrier 720 in accordance with an embodiment of the invention. The reconstitution carrier 720 can be marked at positions where each assembled package 710 is to be placed. The markings can be optically located for correct placement of the assembled packages 710 onto the reconstitution carrier 720. A molding film 810 is pressed to the top surfaces of the assembled packages 710. Film 810 typically does not have cuts or openings. Alternatively, holes such as 820 can be made and spaced on the molding film 810 for the purpose of allowing a molding compound 830 to reach within the assembled packages 710, as well as reach in-between individual assembled packages 710. In an embodiment, holes 820 are placed at positions in-between the individual assembled packages 710. In another embodiment, the molding compound 830 is under vacuum to facilitate movement of the molding compound 830 to reach all open spaces within and in-between the assembled packages 710. The molding film 810 on top of the assembled packages 710 keeps the contact pads on the upper surfaces of the interposer substrates clean and free from any molding compound 830. Likewise, the reconstitution carrier 720 on the bottom of the assembled packages 710 keeps the contact pads on the lower surfaces of the die-attach substrates clean and free from any molding compound 830.

Fig. 8B illustrates removal of the molding film 810 and the reconstitution carrier 720. An adhesive tape type of reconstitution carrier 720 can be removed by mechanical de-taping or applying UV light to reconstitution carrier 720 to deactivate the adhesive nature of the tape. Solder balls 840 are attached to the contact pads on the bottom surfaces of the die-attach substrates to form a ball grid array (BGA) of each assembled package 710. Solder flux can be applied to the contact pads of the die-attach substrate to hold the solder balls 840 in place until reflowing is completed. Embodiments for a reconstituted semiconductor package can be applied to most types of semiconductor packages, such as but not limited to fine-pitch ball grid arrays (FBGA), pin grid arrays (PGA), column grid arrays (CGA), land grid arrays (LGA), z-interconnect arrays, as well as others.

Another embodiment includes using the reconstitution carrier 720 illustrated in Fig. 8A as a solder stencil. The reconstitution carrier 720 can be made of a polymer or photoimageable material, which can be patterned when exposed to ultraviolet (UV) light. A solder mask containing a plurality of openings that match the contact pads on the bottom surfaces of the die-attach substrates is placed over the reconstitution carrier 720. UV light exposes the reconstitution carrier 720 through the openings in the solder mask. The exposed areas of the reconstitution carrier 720 are removed. The solder balls are placed within the openings over the contact pads. A reflow process mechanically and electrically connects the solder balls to their respective contact pads. Another embodiment provides a solder paste (a mixture of solder and flux) that is screen printed into the openings using a solder applicator. A reflow process causes the solder paste to reflow and connect the resulting solder balls or bumps to their respective contact pads. The reconstitution carrier 720 can be removed after the reflow process, or it can remain on the bottom side of the die-attach substrate.

Fig. 8C illustrates an embodiment of the invention in which the assembled and molded packages are singulated into individual reconstitution semiconductor packages 800. The singulation can be implemented by cutting, sawing, laser slicing, or any other method of cutting through molding compound. By exercising embodiments described herein, singulation occurs only through the molding compound. There is no cutting through either the interposer substrate or the die-attach substrate when the interposer substrate and the die-attach substrate are approximately the same size and the molding compound extends beyond the perimeters of the substrates. The interposer substrates mounted to their respective die-attach substrates are separated from one another to form a gap between the packages (see Figs. 7A-8B). Therefore, there is no cutting of either substrate, and as a result, there is no wasted substrate material from the singulation process. Also, the molding along the edges of the substrates will increase the protection of the final package.

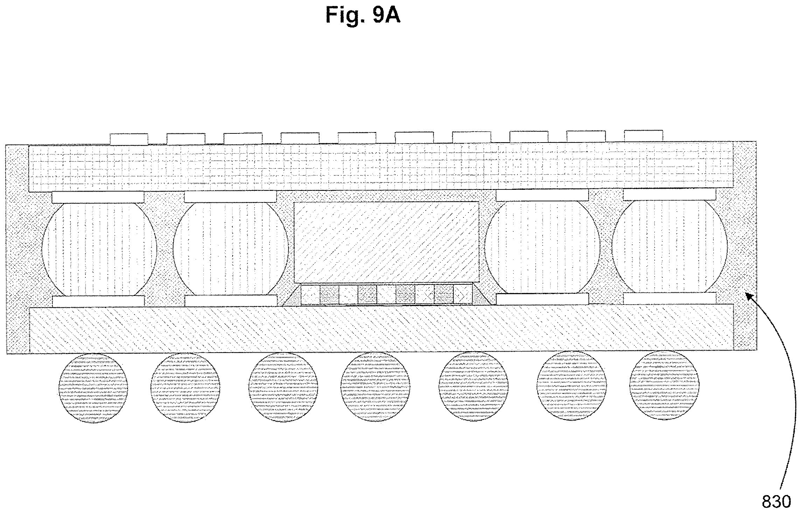

Fig. 9A is an embodiment of the invention illustrating a variation of the process illustrated in Fig. 5D, where an adhesive 560 was applied to the back side of the IC 410. The adhesive 560 was also adhered to the interposer substrate 510 when the interposer substrate 510 was mounted to the die-attach substrate 420. Fig. 9A illustrates an absence of adhesive between the IC and the interposer substrate. Instead, the molding compound 830 fills the gap between the IC and the interposer substrate. A vacuum molding process helps to insure that the molding compound reaches all open spaces within the package.

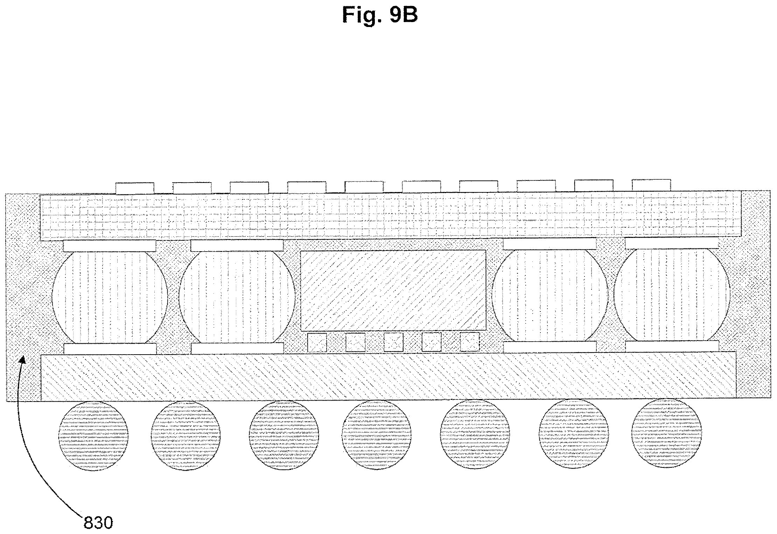

Fig. 9B is a further embodiment illustrating the same device and process illustrated in Fig. 9A, in addition to substituting molding compound 830 for the capillary underfill material between the IC and the die-attach substrate. A vacuum molding process helps to insure that the molding compound reaches all open spaces within the package.

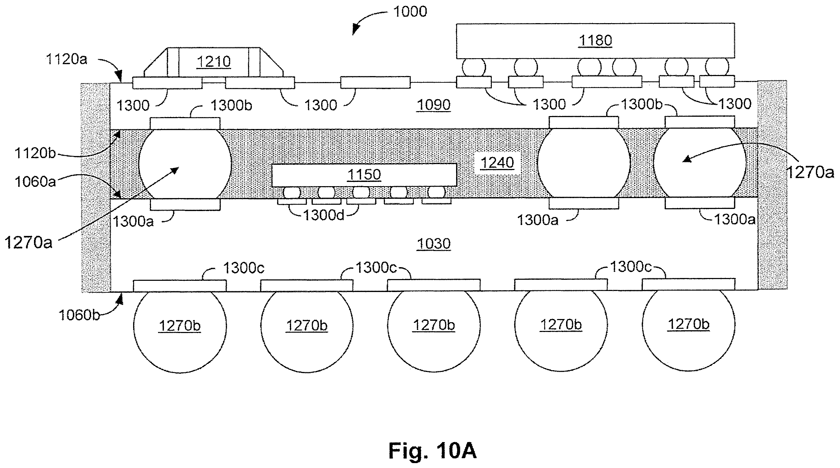

Fig. 10A is an illustration of an interposer package-on-package semiconductor device 1000 in accordance with a further embodiment of the present invention. An interposer substrate 1090 is mounted to a die-attach substrate 1030 by means of solder balls 1270a. The solder balls 1270a are connected to the bottom surface 1120b of the interposer substrate 1090 by means of contact pads 1300b, and the solder balls 1270a are connected to the top surface 1060a of the die-attach substrate 1030 by means of contact pads 1300a. A flip chip integrated circuit 1150 is connected to the top surface 1060a of the die-attach substrate 1030 by means of contact pads 1300d. A molding compound 1240 is filled within all open spaces between the interposer substrate 1090 and the die-attach substrate 1030, as well as along the edges of the connected interposer substrate 1090 and the die-attach substrate 1030. External solder balls 1270b are attached to the bottom surface 1060b of the die-attach substrate 1030 by means of contact pads 1300c. Additional devices such as a surface mount device 1210 and a flip chip device 1180 are connected to the top surface 1120a of the interposer substrate 1090 by means of contact pads 1300.

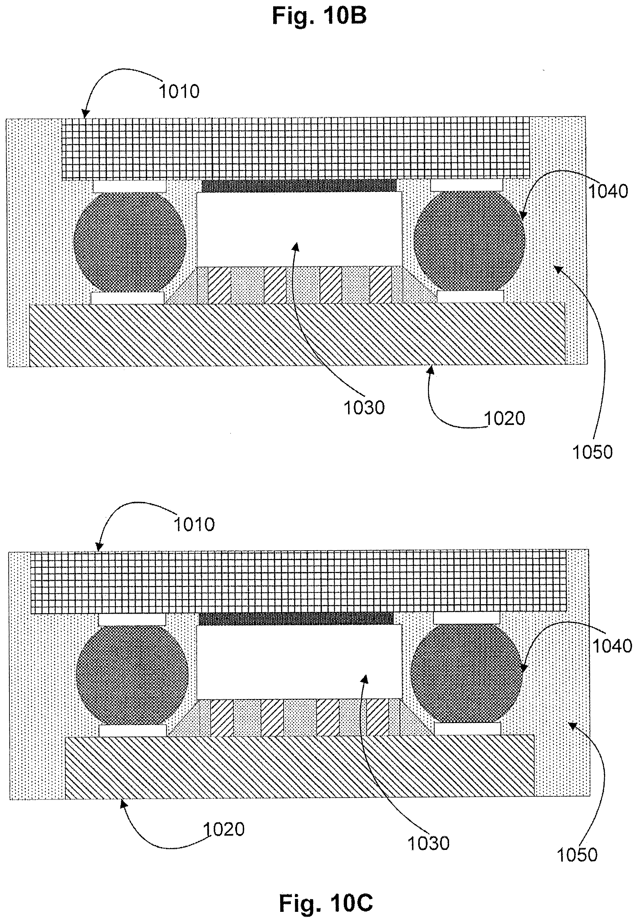

Fig. 10B is an illustration of a further embodiment showing a flip chip IC 1030 connected to a die-attach substrate 1020, and an interposer substrate 1010 connected to the die-attach substrate 1020 by solder balls 1040. Encapsulation 1050 is filled in between the interposer substrate 1010 and the die-attach substrate 1020 and around the IC. The encapsulation 1050 is also filled around the sides of both substrates. However, the interposer substrate 1010 is smaller than the die-attach substrate. In Fig. 10C, a similar flip chip package is illustrated, in which the interposer substrate 1010 is larger than the die-attach substrate 1020. Although not illustrated, the flip chip packages of Figs. 10B and 10C would have solder balls connected to the bottom surface of the die-attach substrate 1020, as illustrated in earlier figures.

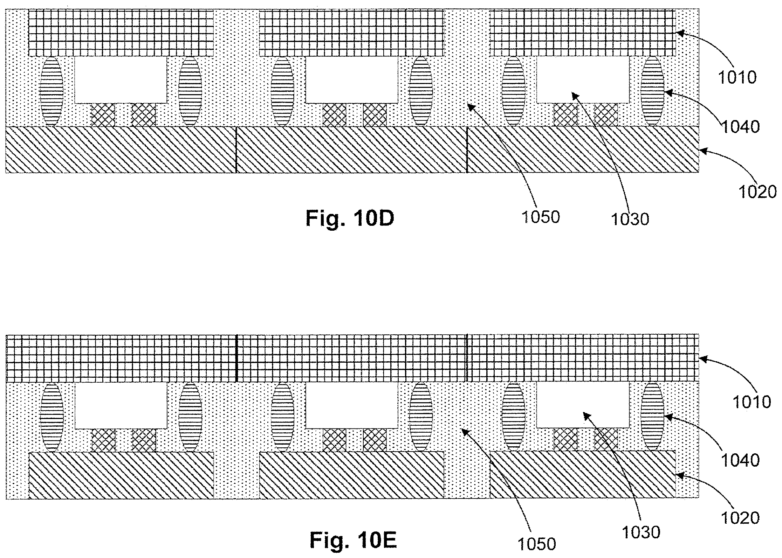

Fig. 10D is an of an arrangement useful for understanding the present invention showing a plurality of die-attach substrates 1020, with associated flip chip ICs 1030 connected thereto, as well as associated interposer substrates 1010 connected to the die-attach substrates 1020 by solder columns or conductive posts 1040. Encapsulation 1050 is filled in between the interposer substrates 1010 and the die-attach substrates 1020. The die-attach substrates 1020 are abutted next to each other, so the encapsulation 1050 only resides along the sides of the interposer substrates 1010 and not along the sides of the die-attach substrates 1020. In an embodiment, the die-attach substrates 1020 may be previously singulated, tested, and grouped together on a carrier, such as previously described. In another embodiment, the die-attach substrate 1020 may be one whole substrate or wafer, which is singulated during the final singulation process to form the individual packages.

Fig. 10E is similar to the packages illustrated in Fig. 10D, except the interposer substrates 1010 are abutted next to each other, so the encapsulation 1050 only resides along the sides of the die-attach substrates 1020 and not along the sides of the interposer substrates 1010. In an embodiment, the interposer substrates 1010 may be previously singulated, tested, and grouped together on a carrier, such as previously described. In another embodiment, the interposer substrate 1010 may be one whole substrate or wafer, which is singulated during the final singulation process to form the individual packages.

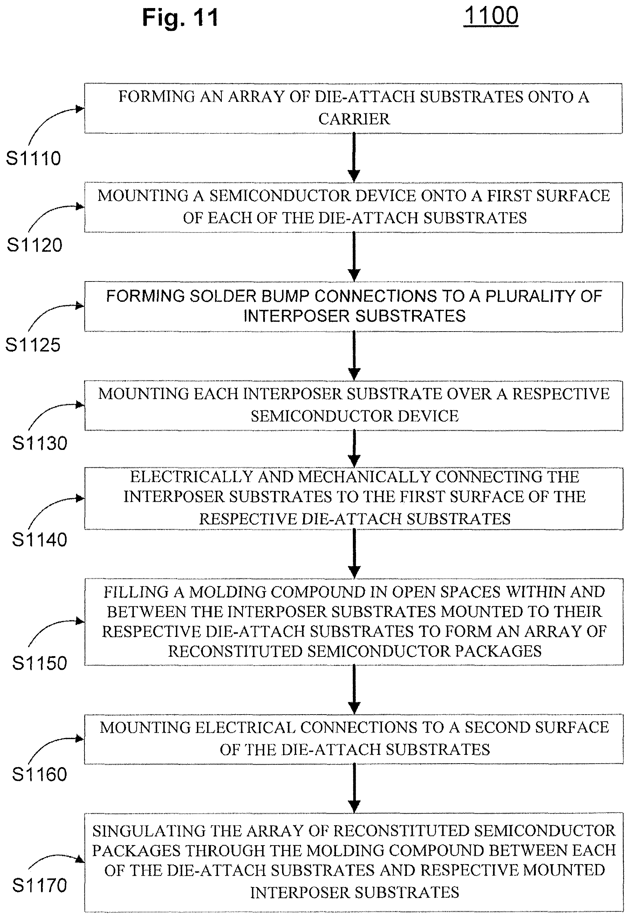

Fig. 11 is a flowchart for a method of forming a semiconductor package 1100, such as a reconstituted interposer package-, in accordance with an embodiment of the invention. An array of die-attach substrates is formed onto a carrier in step S1110. The array of individual die-attach substrates may contain reconstituted working substrates, wherein the substrates were previously tested and only the working substrates are held for further processing. The carrier may be comprised of an adhesive carrier. A semiconductor device is mounted onto a first surface of each of the die-attach substrates in step S1120. In an embodiment, the semiconductor device is a flip chip device. In another embodiment, the semiconductor device is a wire bonded device.

Solder ball connections are formed to a plurality of interposer substrates in step S1125. Each interposer substrate is mounted over a respective semiconductor device in step S1130. The interposer substrates are electrically and mechanically connected to the first surface of the respective die-attach substrates, via the solder ball connections in step S1140. In an embodiment, the die-attach substrate and the interposer substrate are approximately the same size. In another embodiment, the die-attach substrate is larger than the interposer substrate. In still another embodiment, the die-attach substrate is smaller than the interposer substrate. A molding compound is filled in open spaces within and between the interposer substrates mounted to their respective die-attach substrates to form an array of reconstituted semiconductor packages in step S1150. In an embodiment, the array of packages has a gap between each of the die-attach substrates and their respective mounted interposer substrates. As a result, the molding compound fills the gaps between each reconstituted semiconductor package of a die-attach substrate and mounted interposer substrate.

Electrical connections are mounted to a second surface of the die-attach substrates in step S1160. In an embodiment, the electrical connections are mounted in a grid array pattern. The array of reconstituted semiconductor packages are singulated through the molding compound between each of the die-attach substrates and respective mounted interposer substrates in step S1170. The singulation cuts through the molding compound only. Since there is a gap between each pair of die-attach substrates and respective mounted interposer substrates, neither substrate is cut by the singulation process.

The methods and devices described herein are exemplary and are given to illustrate the features and processes of certain embodiments. For example, preparation of the interposer substrate and electrical connections could be executed before preparation of the IC and die-attach substrate connections. As another example, the interposer substrate processing could be con-current with the IC and die-attach substrate processing.

Embodiments described herein for a reconstituted interposer semiconductor package can be used in many applications, including but not limited to the networking, mobile, wireless, wearable electronics, and broadband. In the networking application, the reconstituted interposer semiconductor package described herein can be used in multi-core processors, knowledge-based processors, server message block (SMB) processors, encryption coprocessors, and security processors. In the mobile, wireless applications, and wearable applications, the reconstituted interposer semiconductor package described herein can be used in 3G baseband processors, LTE baseband processors, mobile video processors, mobile graphics processors, application processors, touch controllers, wireless power, Internet of things (IoT) and wearable system-on-chips (SoCs), wireless video, and antennas. In the broadband applications, the reconstituted interposer semiconductor package described herein can be used in cable set-top boxes (STBs), satellite STBs, Internet Protocol (IP) STBs, terrestrial STBs, ultra high definition (HD) processors, STB graphics processors, and STB security processors. These devices and systems can be used in products including but not limited to routers, smartphones, tablets, personal computers, and wearable devices such as watches, shoes, clothes, and glasses.

The foregoing discussion discloses and describes merely exemplary embodiments of the present invention, which is defined by the appended claims.

## Claims

1. A semiconductor package (800), comprising:
a die attach substrate (420) having a semiconductor device (410) mounted to a first surface thereof and having electrical connections mounted to a second surface thereof;
an interposer substrate (510) mounted on the first surface of the die-attach substrate (420) and straddling the semiconductor device (410), the interposer substrate (510) being electrically connected to contact pads on the first surface of the die-attach substrate (420) via solder ball (550) or conductor post connections; a singulated molding compound (830) filled within open spaces between the interposer substrate (510) and the first surface of the die-attach substrate (420), wherein singulated surfaces of the molding compound (830) reside along the edges of the interposer substrate (510) and the die-attach substrate (420); and external electrical connections formed in a grid array on the second surface of the die-attach substrate (420).

2. The semiconductor package of claim 1, further comprising one or more of:
the semiconductor device comprises a flip chip or wire-bonded device;
the electrical connections comprise a grid array of conductors; and
the size of the interposer substrate is different from the size of the die-attach substrate.

3. A baseband microprocessor, a set-top-box microprocessor, a server message block microprocessor, or an encryption/security microprocessor comprising or more of the semiconductor packages of claim 2 assembled therein.

4. The semiconductor package of claim 1, wherein:
the interposer substrate (510) comprises upper contact pads (520) on a first surface and lower contact pads (540) on a second surface;
the lower contact pads (520) are electrically connected to conductive vias (530) connecting respective one of the upper and lower contact pads (520, 540).

5. A molded array of semiconductor packages, comprising:
an array of individual spaced apart die-attach substrates (420);
a plurality of semiconductor devices (410), each mounted and electrically connected to a first surface of a respective one of the die-attach substrates (420);
a plurality of individual spaced apart interposer substrates (510), each mounted over a respective one of the semiconductor devices (410) and electrically connected to the first surface of a respective one of the associated die-attach substrates (420) via solder ball (550) or conductor post connections;
a molding compound (830) filled within open spaces between and around the edges of each of the interposer substrates (510) and the die-attach substrates (420) to form an array of molded semiconductor packages; and
electrical connections mounted in a grid array on a second surface of each of the die-attach substrates (410).

6. The molded array of semiconductor packages according to claim 5, wherein: the plurality of the die-attach substrates (420) are arranged in an array on a carrier (720).

7. A method of forming a semiconductor package, comprising:
forming an array of a plurality of spaced apart die-attach substrates (420);
mounting and electrically connecting a plurality of semiconductor devices (410) onto a respective first surface of each of the die-attach substrates (420);
mounting each of a plurality of spaced apart interposer substrates (510) over a respective one of the plurality of semiconductor devices (410) to be electrically connected to the first surface of a respective one of the plurality of die-attach substrates (420) via solder ball (550) or conductor post connections;
filling a molding compound (830) in open spaces between and around the edges of the plurality of interposer substrates (510) and the plurality of die-attach substrates (420) to form an array of semiconductor packages;
the molding compound (830) filling a gap between each adjacent die-attach substrates (420) and interposer substrates (510); and
singulating the array of semiconductor packages through the gaps to provide a plurality of molded semiconductor packages; such that
after the singulation, the molding compound (830) covers both the edges of the die-attach substrates (420) and the edges of the interposer substrates (510).

8. The method of claim 7, further comprising:
forming the array of the plurality of die-attach substrates onto an adhesive tape carrier.

9. The method of claim 8, further comprising:
exposing portions of the adhesive tape carrier through a solder mask to form a solder stencil.

10. The method of claim 9, further comprising:
forming solder electrical connections within the exposed portions of the solder stencil.

## Patentansprüche

1. Halbleiterpackung (800), die umfasst:
- ein Chipbefestigungssubstrat (420), das eine Halbleitereinrichtung (410), die an einer ersten Oberfläche desselben angebracht ist, und elektrische Verbindungen aufweist, die an einer zweiten Oberfläche desselben angebracht sind,
- ein Interposer-Substrat (510), das an der ersten Oberfläche des Chipbefestigungssubstrats (420) angebracht ist und die Halbleitereinrichtung (410) überspannt, wobei das Interposer-Substrat (510) über Lotkugel- (550) oder Leiterstützenverbindungen mit Kontaktflecken auf der ersten Oberfläche des Chipbefestigungssubstrats (420) elektrisch verbunden ist,
- eine vereinzelte Formmasse (830), die in offene Räume zwischen dem Interposer-Substrat (510) und der ersten Oberfläche des Chipbefestigungssubstrats (420) gefüllt ist, wobei sich vereinzelte Oberflächen der Formmasse (830) längs der Kanten des Interposer-Substrats (510) und des Chipbefestigungssubstrats (420) befinden, und
- externe elektrische Verbindungen, die auf der zweiten Oberfläche des Chipbefestigungssubstrats (420) in einer Gitteranordnung ausgebildet sind.

2. Halbleiterpackung nach Anspruch 1, wobei:
- die Halbleitereinrichtung einen Flip-Chip oder eine drahtgebondete Einrichtung umfasst,
- die elektrischen Verbindungen eine Gitteranordnung von Leitern umfassen, und/oder
- sich die Größe des Interposer-Substrats von der Größe des Chipbefestigungssubstrats unterscheidet.

3. Basisbandmikroprozessor, Set-Top-Box-Mikroprozessor, Servernachricht-Blockmikroprozessor oder Verschlüsselungs-/Sicherheitsmikroprozessor, in dem eine oder mehrere der Halbleiterpackungen nach Anspruch 2 verbaut sind.

4. Halbleiterpackung nach Anspruch 1, wobei:
- das Interposer-Substrat (510) obere Kontaktflecken (520) auf einer ersten Oberfläche und untere Kontaktflecken (540) auf einer zweiten Oberfläche umfasst,
- die unteren Kontaktflecken (540) mit leitfähigen Durchkontaktierungen (530) elektrisch verbunden sind, die jeweilige der oberen und unteren Kontaktflecken (520, 540) miteinander verbinden.

5. Formanordnung von Halbleiterpackungen, die umfasst:
- eine Anordnung einzelner unter Abstand voneinander angeordneter Chipbefestigungssubstrate (420),
- mehrere Halbleitereinrichtungen (410), die jeweils an einer ersten Oberfläche eines jeweiligen der Chipbefestigungssubstrate (420) angebracht und mit dieser elektrisch verbunden sind,
- mehrere einzelne unter Abstand voneinander angeordnete Interposer-Substrate (510), die jeweils über einer jeweiligen der Halbleitereinrichtungen (410) angebracht und über Lotkugel- (550) oder Leiterstützenverbindungen mit der ersten Oberfläche eines jeweiligen der zugeordneten Chipbefestigungssubstrate (420) elektrisch verbunden sind,
- eine Formmasse (830), die in offene Räume zwischen den und um die Kanten jedes der Interposer-Substrate (510) und der Chipbefestigungssubstrate (420) gefüllt ist, um eine Anordnung geformter Halbleiterpackungen auszubilden, und
- elektrische Verbindungen, die auf einer zweiten Oberfläche eines jeden der Chipbefestigungssubstrate (420) in einer Gitteranordnung angebracht sind.

6. Formanordnung von Halbleiterpackungen nach Anspruch 5, wobei:
- die mehreren Chipbefestigungssubstrate (420) in einer Anordnung auf einem Träger (720) angeordnet sind.

7. Verfahren zum Ausbilden einer Halbleiterpackung, das umfasst:
- Ausbilden einer Anordnung mehrerer voneinander unter Abstand angeordneter Chipbefestigungssubstrate (420),
- Anbringen und elektrisches Verbinden mehrerer Halbleitereinrichtungen (410) an und mit einer jeweiligen ersten Oberfläche eines jeden der Chipbefestigungssubstrate (420),
- Anbringen eines jeden von mehreren unter Abstand voneinander angeordneten Interposer-Substraten (510) über einer jeweiligen der mehreren Halbleitereinrichtungen (410), die über Lotkugel- (550) oder Leiterstützenverbindungen mit der ersten Oberfläche eines jeweiligen der mehreren Chipbefestigungssubstrate (420) elektrisch zu verbinden sind,
- Füllen einer Formmasse (830) in offene Räume zwischen den und um die Kanten der mehreren Interposer-Substrate (510) und der mehreren Chipbefestigungssubstrate (420), um eine Anordnung von Halbleiterpackungen auszubilden,
- wobei die Formmasse (830) einen Spalt zwischen jedem der zueinander benachbarten Chipbefestigungssubstrate (420) und Interposer-Substrate (510) ausfüllt, und
- Vereinzeln der Anordnung von Halbleiterpackungen über die Spalte, um mehrere geformte Halbleiterpackungen so bereitzustellen, dass
- die Formmasse (830) nach der Vereinzelung sowohl die Kanten der Chipbefestigungssubstrate (420) als auch die Kanten der Interposer-Substrate (510) bedeckt.

8. Verfahren nach Anspruch 7, das ferner umfasst:
- Ausbilden der Anordnung der mehreren Chipbefestigungssubstrate auf einem Klebebandträger.

9. Verfahren nach Anspruch 8, das ferner umfasst:
- Freilegen von Abschnitten des Klebebandträgers über eine Lötmaske, um eine Lötschablone auszubilden.

10. Verfahren nach Anspruch 9, das ferner umfasst:
- Ausbilden elektrischer Lötverbindungen in den freigelegten Abschnitten der Lötschablone.

## Revendications

1. Boîtier semi-conducteur (800), comprenant :
un substrat de fixation de puce (420) ayant un dispositif semi-conducteur (410) monté sur une première surface de celui-ci et ayant des connexions électriques montées sur une seconde surface de celui-ci ;
un substrat intercalaire (510) monté sur la première surface du substrat de fixation de puce (420) et chevauchant le dispositif semi-conducteur (410), le substrat intercalaire (510) étant connecté électriquement à des plots de contact sur la première surface du substrat de fixation de puce (420) via des connexions par billes de soudure (550) ou bornes conductrices ;
un composé de moulage individualisé (830) rempli dans des espaces ouverts entre le substrat intercalaire (510) et la première surface du substrat de fixation de puce (420), dans lequel des surfaces individualisées du composé de moulage (830) résident le long des bords du substrat intercalaire (510) et du substrat de fixation de puce (420) ; et
des connexions électriques externes formées selon un réseau eh grille sur la seconde surface du substrat de fixation de puce (420).

2. Boîtier semi-conducteur selon la revendication 1, comprenant en outre un ou plusieurs éléments parmi :
le dispositif semi-conducteur comprend une puce retournée ou un dispositif à liaison filaire ;
les connexions électriques comprennent un réseau en grille de conducteurs ; et
la taille du substrat intercalaire est différente de la taille du substrat de fixation de puce.

3. Microprocesseur en bande de base, microprocesseur de boîtier décodeur,
microprocesseur de bloc de messages de serveur ou microprocesseur de chiffrement/ sécurité comprenant ou plusieurs des boîtiers semi-conducteurs de la revendication 2 assemblés à l'intérieur.

4. Boîtier semi-conducteur selon la revendication 1, dans lequel :
le substrat intercalaire (510) comprend des plots de contact supérieurs (520) sur une première surface et des plots de contact inférieurs (540) sur une seconde surface ;
les plots de contact inférieurs (520) sont connectés électriquement à des vias conducteurs (530) connectant respectivement l'un des plots de contact supérieurs et inférieurs (520, 540).

5. Réseau moulé de boîtiers semi-conducteurs, comprenant :
un réseau de substrats de fixation de puce individuels espacés (420) ;
une pluralité de dispositifs semi-conducteurs (410), chacun étant monté et connecté électriquement à une première surface d'un substrat de fixation de puce respectif des substrats de fixation de puce (420) ;
une pluralité de substrats intercalaires individuels espacés (510), montés chacun sur un dispositif semi-conducteur respectif des dispositifs semi-conducteurs (410) et connectés électriquement à la première surface d'un substrat de fixation de puce respectif des substrats de fixation de puce (420) associés via des connexions par billes de soudure (550) ou bornes conductrices ;
un composé de moulage (830) rempli dans des espaces ouverts entre et autour des bords de chacun des substrats intercalaires (510) et des substrats de fixation de puce (420) pour former un réseau de boîtiers semi-conducteurs moulés ; et
des connexions électriques montées selon un réseau en grille sur une seconde surface de chacun des substrats de fixation de puce (410).

6. Réseau moulé de boîtiers semi-conducteurs selon la revendication 5, dans lequel :
la pluralité des substrats de fixation de puce (420) sont disposés en un réseau sur un support (720).

7. Procédé de formation d'un boîtier semi-conducteur, comprenant :
la formation d'un réseau d'une pluralité de substrats de fixation de puce espacés (420) ;
le montage et la connexion électrique d'une pluralité de dispositifs semi-conducteurs (410) sur une première surface respective de chacun des substrats de fixation de puce (420) ;
le montage de chacun d'une pluralité de substrats intercalaires espacés (510) sur un dispositif semi-conducteur respectif de la pluralité de dispositifs semi-conducteurs (410) pour être connecté électriquement à la première surface d'un substrat de fixation de puce respectif de la pluralité de substrats de fixation de puce (420) via des connexions par billes de soudure (550) ou - bornes conductrices ;
le remplissage d'un composé de moulage (830) dans des espaces ouverts entre et autour des bords de la pluralité de substrats intercalaires (510) et de la pluralité de substrats de fixation de puce (420) pour former un réseau de boîtiers semi-conducteurs ;
le composé de moulage (830) remplissant un espace entre chaque substrats de fixation de puce (420) et substrats intercalaires (510) adjacents ; et
l'individualisation du réseau de boîtiers semi-conducteurs à travers les espaces pour fournir une pluralité de boîtiers semi-conducteurs moulés ; de telle sorte qu'après l'individualisation, le composé de moulage (830) couvre à la fois les bords des substrats de fixation de puce (420) et les bords des substrats intercalaires (510).

8. Procédé selon la revendication 7, comprenant en outre :
la formation du réseau de la pluralité de substrats de fixation de puce sur un support de ruban adhésif.

9. Procédé selon la revendication 8, comprenant en outre :
l'exposition de parties du support de ruban adhésif à travers un masque de soudure pour former un pochoir de soudure.

10. Procédé selon la revendication 9, comprenant en outre :
la formation de connexions électriques par soudure à l'intérieur des parties exposées du pochoir de soudure.
